# EUROPÄISCHE PATENTSCHRIFT

(11) **EP 1 775 353 B1**
(45) Veröffentlichungstag und Bekanntmachung des Hinweises auf die Patenterteilung: **08.10.2008**
(21) Anmeldenummer: 05020153.2
(22) Anmeldetag: 15.09.2005
(51) Int. Cl.: C23C 14/35, C23C 14/56, H01J 37/34

(54) **Beschichtungsanlage und Verfahren zum Betrieb einer Beschichtungsanlage**
Coating apparatus and method for operating a coating apparatus
Installation de revêtement et procédé d'opération d'une installation de revêtement

(43) Veröffentlichungstag der Anmeldung: 18.04.2007
(73) Patentinhaber: Applied Materials GmbH & Co. KG, 63755 Alzenau (DE)
(72) Erfinder: Heimel, Oliver, 34590 Wabern (DE)
(74) Vertreter: Bockhorni & Kollegen

(56) Entgegenhaltungen:
- EP-A- 0 492 114
- WO-A-92/01081
- DE-A1- 4 126 236
- GB-A- 1 366 608

## Beschreibung

Diese Anmeldung betrifft eine Beschichtungsanlage zur Beschichtung eines Substrats mittels Sputtern umfasst eine Prozesskammer und ein in der Prozesskammer angeordnetes Target, von dem aus Targetmaterial in Richtung des Substrats zum Beschichten des Substrats absputterbar ist, sowie ein Verfahren zum Betrieb einer Beschichtungsanlage.

Bei herkömmlichen Beschichtungsanlagen müssen neu eingesetzte Targets vor Prozessbeginn über eine gewisse Zeitdauer unter Vakuumbedingungen eingesputtert bzw. konditioniert werden. Dies ist notwendig, da das Sputtertarget vor dem Beginn des eigentlichen, bestimmungsgemäßen Beschichtungsprozesses konditioniert werden muss, um einen störungsfreien Ablauf des Beschichtungsprozesses sicher zu stellen. Insbesondere muss das Target vor Beginn des Prozesses durch allmähliche Steigerung der Sputterleistung auf Betriebstemperatur gebracht werden, da vor allem keramische Targets bei abruptem Einbringen einer hohen Sputterleistung durch thermische Spannungen zerstört werden können. Außerdem ist das Target nach dem Fluten der Beschichtungskammer mit störenden Materialien, beispielsweise mit Wassermolekülen oder Staub, der von Reinigungsarbeiten herrührt, belegt. Auch wenn die Targetoberfläche nach der Herstellung von Rückständen, z.B. von Schneidöl, Fingerabdrücken etc. gereinigt wird, so können diese Verunreinigungen in tiefere Molekülebenen des Targetmaterials eingedrungen und durch die Reinigungsvorgänge nicht zu entfernen sein. Daher dient das Einsputtern unter anderem auch dazu, die Targetoberfläche von diesen Verunreinigungen zu befreien, bevor der eigentliche Beschichtungsprozess beginnt.

Während der Einsputterphase wird eine Vielzahl von Substraten, beispielsweise eine Anzahl von etwa 80 bis 100 Substraten, benötigt. Dieser Bedarf an Substraten, die nach jedem Targetwechsel zum Einsputtern des Targets benötigt werden, erzeugt hohe Kosten. Die Substrate müssen ferner, da sie für weitere Verwendungen unbrauchbar sind, entsorgt werden.

Um diese Kosten zu senken, können beispielsweise in Beschichtungsanlagen mit vertikaler Ausrichtung der Substrate, statt teuere Substrate auf Substratträgern ("Carrier") zu verwenden, sogenannte "Dummy"-Träger zum Einsputtern verwendet. Die Verwendung der Dummies hat jedoch zwei Nachteile. Zum einen müssen auch diese nach der Einsputterphase entsorgt oder gereinigt und staubfrei gelagert werden, zum anderen werden die später verwendeten Prozess-Carrier nicht auf Betriebstemperatur gebracht, die im Betrieb an anlageninternen Heizeinrichtungen vorbei geführt werden. D. h. die Einsputterphase wird nicht genutzt, um die gewünschten Prozessbedingungen herzustellen. Des Weiteren müssen die Dummie-Carrier zusätzlich zu den Prozess-Carriern bereitgestellt werden.

Eine andere Möglichkeit besteht darin, in den Zwischenraum zwischen dem Target und dem Substrat eine sogenanntes "Shutter"-Blech hineinzuschwenken, das in der Einsputterphase die gesputterten Teilchen aufnehmen und das Substrat vor einer unerwünschten Beschichtung schützen soll. Nachteilig ist hierbei neben der aufwändigen Mechanik zum Schwenken des Bleches, dass dieses Shutter-Blech in Substratnähe schwenkbar angeordnet werden muss, so dass während des Produktionsvorgangs eventuell abplatzende Partikel der Beschichtung auf das Substrat gelangen können. Jede weitere Vorrichtung zum Abdecken der im Einsputtermodus beschichteten Oberflächen würde diese Lösung weiter verteuern.

Ausgehend davon besteht die Aufgabe der vorliegenden Erfindung darin, eine Beschichtungsanlage und ein Verfahren zum Betrieb einer Beschichtungsanlage bereitzustellen, durch die der Materialaufwand, insbesondere der Aufwand an Substraten, beim Einfahren der Anlage verringert wird.

Diese Aufgabe wird gelöst durch eine Beschichtungsanlage gemäß Anspruch 1 und ein Verfahren gemäß Anspruch 21.

Die erfindungsgemäße Beschichtungsanlage zur Beschichtung eines Substrats mittels Sputtern umfasst eine Prozesskammer und ein in der Prozesskammer angeordnetes Target, von dem aus Targetmaterial in Richtung des Substrats zum Beschichten des Substrats absputterbar ist, wobei die Beschichtungsanlage Mittel zur Ausrichtung der Sputterrichtung in eine erste Richtung zum Betreiben der Beschichtungsanlage in einem ersten Betriebsmodus, und zur Ausrichtung der Sputterrichtung in eine zweite Richtung zum Betreiben der Beschichtungsanlage in einem zweiten Betriebsmodus aufweist. Die Mittel sind zur wahlweisen Einstellung der Sputterrichtungen ausgebildet. So kann beispielsweise in jedem Betriebsmodus bestimmt werden, ob die Sputterrichtung zum Substrat hin weisen soll oder in eine davon abgewandte Richtung gesputtert werden soll.

Unter der Sputterrichtung soll dabei die Richtung, in die sich das abgesputterte Material im Wesentlichen bewegt, verstanden werden. Dem Fachmann ist klar, dass eine Streuung der Bewegungsrichtungen der Teilchen bezüglich einer Hauptsputterrichtung auftreten. Eine Hauptbewegungsrichtung ist jedoch bestimmbar, die als Sputterrichtung bezeichnet werden kann.

Die Ausrichtung der Sputterrichtung bzw. die Veränderung der Ausrichtung bei einem Wechsel des Betriebsmodus kann durch Bedienpersonal vorgenommen werden. Die Anlage ist so ausgelegt, dass die Einstellung der Sputterrichtung ohne Eingriff in die Beschichtungskammer, also ohne vorheriges Fluten der Kammer, vorgenommen werden kann.

Die erste Richtung ist eine zum Substrat hin gerichtete Richtung, und die zweite Richtung eine vom Substrat abgewandte Richtung. Somit kann bei verschiedenen Betriebsphasen flexibel eingestellt werden, ob durch die Anlage transportierte Substrate in dieser Phase beschichtet werden sollen oder nicht.

Unter einer Richtung zum Substrat hin soll im Wesentlichen eine Richtung senkrecht zur Substratoberfläche bzw. zur Transportebene, in der die Substrate durch die Beschichtungsanlage gefördert werden, verstanden werden. Die Richtung zum Substrat hin bedeutet ferner, dass die in Sputterrichtung vom Target abgesputterten Teilchen ohne wesentliche weitere Streuungen die Substratoberfläche erreichen können.

Die Beschichtungsanlage ist bevorzugt zum Einsputtern des Targets in den zweiten Betriebsmodus, und zum Beschichten des Substrats durch Absputtern von Material vom Target in den ersten Betriebsmodus einstellbar. Die Möglichkeit, die Sputterrichtung zwischen den wenigstens zwei Positionen (die zweite zum Einsputtern in eine vom Substrat abgewandte Richtung, die erste zum regulären, bestimmungsgemäßen Beschichtungsbetrieb in eine Richtung zum Substrat hin gerichtet) zu ändern, ohne die Anlage für eine Änderung der Ausrichtung zu fluten, bestimmt die vorliegende Erfindung.

Bei der vorliegenden Erfindung sind die Kathoden so ausgebildet, dass die Sputterrichtung im Wesentlichen senkrecht zur Oberfläche des Targets ausgerichtet ist. Die Sputterrichtung im regulären Beschichtungsbetrieb ist damit im Wesentlichen senkrecht zur Targetoberfläche und senkrecht zur Substratoberfläche ausgerichtet. Damit steht die Targetoberfläche, von der bevorzugt abgesputtert wird, im Wesentlichen parallel zur Substratoberfläche.

Beim Einsputtern dagegen soll die Sputterrichtung in eine vom Substrat abgewandte Richtung ausgerichtet sein. Dies bedeutet, dass in Sputterrichtung abgesputterte Teilchen die Substratoberfläche nicht erreichen sollen. Damit soll ein unnötiger Verbrauch von Substraten während der Einsputterphase verhindert werden. Da jedoch ansonsten die Bedingungen innerhalb der Beschichtungsanlage identisch zu den Bedingungen beim bestimmungsgemäßen Beschichtungsvorgang sind, können leere Substrat-Carrier zum Aufheizen durch die Anlage transportiert werden. Dies bedeutet, dass die Zeit des Einsputterns genutzt werden kann, um die für den Betrieb notwendigen Prozessbedingungen herzustellen. Die Carrier sind bereits zu Beginn des bestimmungsgemäßen Beschichtungsbetriebs effektiv einsetzbar.

Unter dem "Einsputtern" soll in diesem Zusammenhang das Einfahren der Beschichtungsanlage bzw. der Vorlaufbetrieb einer Anlage vor dem eigentlichen, bestimmungsgemäßen Beschichtungsvorgang verstanden werden.

Durch die Verwendung der bestimmungsgemäßen Beschichtungsanlage wird der Materialbedarf an Substraten bzw. Dummy-Carriern, die anschließend entsorgt oder gereinigt und gelagert werden müssen, verringert. Dies führt zu Kostenvorteilen beim Betrieb der Anlage.

Die Mittel zur Ausrichtung der Sputterrichtung sind insbesondere derart ausgebildet, dass die Sputterrichtung durch eine Drehung der Sputterrichtung um einen Winkel, insbesondere einen Winkel zwischen 90° und 180°, veränderbar ist. Damit kann die Sputterrichtung von der Substratebene weggedreht werden

Bevorzugt weist die Beschichtungsanlage eine Auffangeinrichtung zum Auffangen von in die erste Richtung vom Target abgesputtertem Material auf. Diese Auffangeinrichtung kann beispielsweise ein Auffangblech sein. Die Auffangeinrichtung ist von ihrer Form und Ausrichtung so ausgebildet bzw. angeordnet, dass während des Einsputterns möglichst keine der abgesputterten Teilchen auf die Transportebene für die Substrate auftreffen, Wände oder andere im Innenraum der Beschichtungskammer angeordnete Komponenten verschmutzen.

Die Auffangeinrichtung kann eine Oberfläche aufweisen, die im Wesentlichen senkrecht zur zweiten Richtung angeordnet ist. Ebenso sind aber auch V-förmige Anordnungen von Affangblechen denkbar, die so angeordnet sind, dass die durch ihren Rand beschriebene Öffnungsfläche im wesentlichen senkrecht zur zweiten Richtung angeordnet ist, wobei die gesputterten Teilchen durch diese Öffnung hindurch treten. Die Auffangeinrichtung sollte jedenfalls so ausgebildet und angeordnet sein, dass die im Einsputtermodus abgesputterten Teilchen auf die Auffangfläche treffen.

Die Beschichtungsanlage weist insbesondere eine Flachkathode auf, die das Target trägt. Flachkathoden weisen eine im Wesentlichen flache Targetoberfläche auf, die im regulären Beschichtungsbetrieb im Wesentlichen parallel zur Transportebene der Substrate steht.

Die Mittel zur Ausrichtung der Sputterrichtung weisen insbesondere einen Drehmechanismus zur Drehung der Flachkathode auf. Mit Hilfe der vorliegenden Erfindung kann die Sputterrichtung während der Einsputterphase gegenüber der Sputterrichtung während des bestimmungsgemäßen Beschichtungsbetriebs gedreht werden. Der Drehmechanismus ist selbstverständlich von außen, d. h. ohne Fluten der Anlage, betätigbar, so dass die Sputterrichtung abhängig davon, ob eingesputtert oder bestimmungsgemäß beschichtet wird, zwischen wenigstens zwei Ausrichtungen gedreht werden kann.

Der Drehmechanismus kann so ausgebildet sein, dass die Flachkathode um eine Längsachse der Kathode drehbar ist.

Die Kathode kann zum Einsputtern des Targets gegenüber der Substratoberfläche um einen Winkel verkippt oder geschwenkt werden. Dies bedeutet, dass die Targetoberfläche bevorzugt seitlich, schräg oder entgegengesetzt nach hinten von der Substratebene weggedreht wird. Dadurch wird verhindert, dass während des Einsputterns abgesputterte Teilchen auf die Transportebene für die Substrate und damit auf die Substrat-Carrier treffen. Ein Verkippen der Kathoden bedeutet außerdem, dass die Drehachse nicht zwingend zentral längs zur Kathode verlaufen muss. Die Drehachse kann zur Längsachse der Kathode sowohl parallel verschoben als auch leicht geneigt sein, so lange die Funktion erfüllt werden kann, die Sputterrichtung während der Einsputterphase vom Target weg zu richten.

Der Drehmechanismus kann einen motorischen Antrieb aufweisen.

Die Beschichtungsanlage weist in einer weiteren Ausführungsform eine Drehkathode auf, die das Target trägt, wobei das Target gegenüber einer Trägerstruktur der Kathode drehbar angeordnet ist. Eine Drehkathode umfasst in der Regel einen zylindrischen Träger, auf den das Targetmaterial aufgebracht ist. Im Betrieb wird das Target rotiert, um eine gleichmäßige Abtragung des Materials zu gewährleisten. Ferner ist ein Magnetsystem vorgesehen, welches die Sputterrichtung wesentlich bestimmt.

Die Beschichtungsanlage kann ein Magnetsystem aufweisen, das mittels eines Drehmechanismus gegenüber der Trägerstruktur der Kathode drehbar angeordnet ist. Die Magnetanordnung kann dabei gegenüber der Kathode zwischen der Einsputter- und der Betriebsposition gedreht werden.

Das Magnetsystem kann an einem Magnetträger angeordnet sein. Dies bedeutet, dass der Träger zusammen mit der Magnetanordnung gegenüber der Kathode drehbar ist.

Die Kathode ist insbesondere mit ihrer Trägerstruktur und dem Magnetsystem mittels eines Drehmechanismus drehbar in der Beschichtungskammer angeordnet.

Der Drehmechanismus kann einen motorischen Antrieb aufweisen.

Die Kathode kann auch Mittel zur Anordnung eines ersten Magnetsystems zur Ausrichtung der Sputterrichtung in die erste Richtung, und Mittel zur Anordnung eines zweiten Magnetsystems zur Ausrichtung der Sputterrichtung in die zweite Richtung aufweisen. Ein rotierbares Magnetron wird also mit einem zweiten, zusätzlichen Magnetfeld ausgestattet. Während das erste Magnetfeld so angeordnet ist, dass das Targetmaterial unter der Einwirkung dieses Magnetfelds in Richtung des Substrats zum Beschichten des Substrats abgesputtert wird, ist das zweite Magnetfeld so angeordnet, dass das Targetmaterial unter der Einwirkung dieses Magnetfelds in eine vom Substrat abgewandte Richtung abgesputtert wird. Durch die Magnetanordnung kann ein Flächenbereich, d. h. ein Winkelbereich oder Sektor ausgewählt werden, längs dem das Targetmaterial bevorzugt abgesputtert wird.

Das erste Magnetsystem ist insbesondere während des ersten Betriebsmodus aktiviert, und das zweite Magnetsystem während des zweiten Betriebsmodus, wobei das jeweils nicht benötigte Magnetsystem deaktiviert ist.

Wird anstelle eines Magnetsystems, das mit Permanentmagneten bestückt ist, ein Magnetsystem verwendet, das mittels Spulen erzeugt wird, so kann auf einfache Weise das jeweils benötigte Magnetfeld aktiviert bzw. deaktiviert werden. Aber auch Magnetsysteme mit Permanentmagneten lassen sich aktivieren bzw. deaktivieren, indem man ein genügend dickes, weichmagnetisches Abschirmblech von ca. 5 mm Stärke vor das jeweils nicht benötigte Magnetsystem bewegt, wobei dieses Abschirmblech das aus den Permanentmagneten austretende Magnetfeld durch seine sehr viel höhere magnetische Permeabilität fast vollständig aufnimmt und damit quasi kurzschließt. Eine andere Möglichkeit besteht darin, die Magnetsysteme im Inneren des Rohrtargets schwenkbar anzuordnen, wobei zum Deaktivieren die Magnetpole zur Drehachse des Rohrtargets hin gedreht werden. Dadurch wird das Feld des jeweiligen nach "hinten" gedrehten Magnetsystems auf der Targetoberfläche so schwach, dass sich kein Magnetron-Sputterprozess ausbilden kann.

Das erste Magnetsystem und/oder das zweite Magnetsystem umfassen also insbesondere Elektromagnete, die durch An- bzw. Abschalten aktivierbar bzw. deaktivierbar sind.

Das erste Magnetsystem und/oder das zweite Magnetsystem können Permanentmagnete umfassen, wobei die Magnetsysteme jeweils durch Anordnung eines Abschirmelements, insbesondere eines weichmagnetischen Abschirmblechs, zwischen das jeweilige Magnetsystem und die Targetoberfläche aktivierbar bzw. deaktivierbar sind.

Das erste Magnetsystem und/oder das zweite Magnetsystem können Permanentmagnete umfassen, und die Magnetsysteme innerhalb des Targets schwenkbar angeordnet sein derart, dass die Magnetsysteme durch Verschwenken der Magnetpole des jeweiligen Magnetsystems bezüglich der Targetoberfläche jeweils aktivierbar bzw. deaktivierbar sind.

Die Aufgabe wird auch gelöst durch ein Verfahren zum Betrieb einer Beschichtungsanlage, insbesondere einer Beschichtungsanlage nach einem der vorhergehenden Ansprüche, mit folgenden Schritten:
a) Einsetzen eines Targets in eine Beschichtungskammer;
b) Evakuieren der Beschichtungskammer;
c) Ausrichten der Sputterrichtung in eine erste, von einer Substratebene abgewandte Richtung;
d) Einsputtern des Targets;
e) Ausrichten der Sputterrichtung in eine zweite, zur Substratebene hin gerichtete Richtung; und
f) Beschichten von Substraten durch Absputtern von Material vom Target,
wobei der Schritt c) vor oder nach dem Schritt b) durchgeführt werden kann.

Zwischen der ersten Richtung und der zweiten Richtung kann insbesondere ein Winkel zwischen 90° und 180° liegen. Die Sputterrichtung beim Einsputtern ist somit gegenüber der Richtung des Substrats, also der Richtung, in die im regulären Beschichtungsbetrieb gesputtert wird, um einen Winkel von wenigstens 90° gedreht. Während des Einsputterns wird also nicht in Richtung des Substrats, sondern - hinsichtlich des Substrats - seitlich, nach schräg hinten oder nach hinten in die dem Substrat entgegengesetzte Richtung gesputtert. Dadurch wird ein unerwünschtes Auftreffen von Beschichtungsmaterial auf die Substrate bzw. Substrat-Carrier verhindert, die während des Aufsputterns durch die Beschichtungskammern bewegt werden.

Im Schritt a) kann neben dem Target in die Beschichtungskammer eine Auffangeinrichtung zum Auffangen von in die erste Richtung abgesputtertem Material eingesetzt werden.

Die Auffangeinrichtung kann so angeordnet und ausgebildet sein, dass die durch ihren Rand beschriebene Öffnungs- bzw. Auftrefffläche im wesentlichen senkrecht zur zweiten Richtung angeordnet ist.

Die Sputterrichtung im Schritt e) kann durch Drehen einer Flachkathode ausgerichtet werden.

Die Sputterrichtung kann bevorzugt um einen Winkel von wenigstens 90° verkippt werden.

Die Sputterrichtung im Schritt e) kann durch Drehen eines Magnetsystems einer Drehkathode oder durch Drehung der ganzen Kathode ausgerichtet werden.

Die Ausrichtung der Sputterrichtung in den Schritten c) und e) kann auch durch Einsetzen bzw. Aktivieren zweier Magnetanordnungen, die in einer Drehkathode radial versetzt angeordnet werden können, erfolgen.

Weitere Merkmale und Vorteile der Erfindung ergeben sich aus der nachfolgenden Beschreibung spezieller Ausführungsbeispiele. Es zeigen:
- Fig. 1a: einen Ausschnitt aus einer Beschichtungsanlage in einer Schnittansicht;
- Fig. 1b: einen Ausschnitt aus einer erfindungsgemäßen Beschichtungsanlage in einer Schnittansicht;
- Fig. 2: eine perspektivische Ansicht eines Kathodenaufbaus mit rotierbarer Kathode;
- Fig. 3: eine Schnittansicht einer erfindungsgemäßen rotierbaren Kathode; und
- Fig. 4: einen Ausschnitt aus einer erfindungsgemäßen Beschichtungsanlage in einer weiteren Ausführungsform.

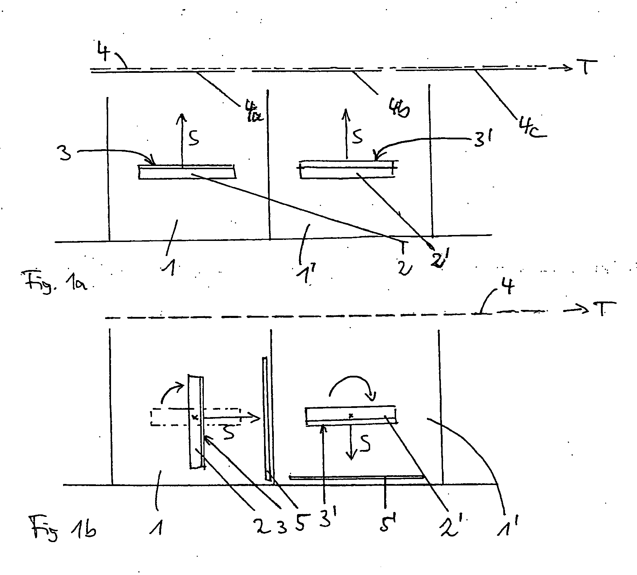

In der Fig. 1a ist ein Teilbereich einer Beschichtungsanlage in einer Schnittansicht dargestellt. Der Ausschnitt umfasst zwei Kompartments 1, 1', in denen jeweils eine Flachkathode 2, 2' angeordnet ist. Von der Targetoberfläche 3, 3' wird Beschichtungsmaterial abgesputtert, um Substrate 4a, 4b, 4c, die in einer Transportrichtung T an den Targets vorbei transportiert werden, zu beschichten. Die Ebene 4, in der sich die Substrate 4a, 4b, 4c während des Beschichtungsprozesses im Wesentlichen angeordnet sind, wird im folgenden als Transport- oder Substratebene 4 bezeichnet.

Die von den Targets 3, 3' abgesputterten Teilchen weisen eine den zu beschichtenden Oberflächen der Substrate 4a, 4b, 4c zugewandte Bewegungsrichtung auf, die als Sputterrichtung S bezeichnet wird. Bei Flachkathoden 2, 2' ist die Sputterrichtung S1 im Wesentlichen senkrecht zur Targetoberfläche 3, 3' ausgerichtet. Da in der Regel die Targetoberfläche 3, 3' im Wesentlichen parallel zur Transportrichtung T der Substrate 4a, 4b, 4c ausgerichtet ist, sind auch die Transportrichtung T und Sputterrichtung S1 im Wesentlichen senkrecht zueinander ausgerichtet. Die Fig. 1a zeigt die Stellung der Kathoden 2, 2' im regulären, bestimmungsgemäßen Beschichtungsbetrieb.

Die Sputterrate der Targets 3, 3' kann gesteigert werden, indem die Kathoden 2, 2' mit einem aus dem Stand der Technik bekannten Magnetfeld versehen werden. Die Magnetanordnung, die das Magnetfeld erzeugt, liegt in der Regel, bezogen auf die Transportebene 4, hinter dem Targetmaterial.

Während einer Einsputterphase der Targets 3, 3', wie sie beispielsweise nach einem Targetwechsel erforderlich ist, werden jedoch bei der Ausrichtung der Kathoden 2, 2' wie in Fig 1a eine Reihe von Substraten 4a, 4b, 4c qualitativ unzureichend beschichtet, so dass die während dieser Vorlaufphase an den Targets 3, 3' vorbei transportierten Substrate 4a, 4b, 4c danach entsorgt werden müssen. Der Einsatz dieser Substrate 4a, 4b, 4c führt zu einem relativ hohen Kostenaufwand, bevor die Anlage in den regulären Beschichtungsbetrieb übergeht.

Die Fig. 1b offenbart eine erfindungsgemäße Lösung dieses Problems. Die Flachkathoden 2, 2' bzw. die Kompartments 1, 1' sind mit einer Vorrichtung zum Drehen der Kathoden 2, 2' in einer von der regulären Ausrichtung (vgl. Fig. 1a) abweichenden Ausrichtung versehen. Die Vorrichtung zum Drehen ist selbstverständlich derart ausgebildet, dass sie von außerhalb, also ohne Öffnen und Fluten der Anlage, und während des Betriebs der Anlage betätigt werden kann. Dies bedeutet, dass zwischen den beiden Betriebsmodi "Einsputtern" und "bestimmungsgemäßer Beschichtungsbetrieb" auch während des Betriebs der Anlage durch Bedienpersonal umgeschaltet werden kann.

Durch das Drehen der Flachkathoden 2, 2' wird auch die Sputterrichtung S, die für den regulären Betrieb nach Fig. 1a zu den Substraten 4a, 4b, 4c hin gerichtet war, von den Substraten 4a, 4b, 4c bzw. von der Transportebene 4 der Substrate 2 weg gedreht (Richtung S2).

In der Fig. 1b ist ein erstes Target 3, das im ersten Beschichtungskompartment 1 angeordnet ist, um etwa 90° gegenüber seiner ursprünglichen Ausrichtung (in Strichlinien dargestellt) gedreht. Damit dreht sich auch die Sputterrichtung S in eine Richtung parallel zur Oberfläche der Substrate 4a, 4b, 4c bzw. parallel zur Transportebene T.

Parallel zur Targetoberfläche 3 der um 90° gedrehten Flachkathode 2 ist ein Blech 5 als Auffänger für das während der Einsputterphase vom Target 3 abgesputterte Material angeordnet.

Im zweiten Kompartment 1' wird die Kathode 2' während der Einsputterphase gegenüber ihrer Betriebsposition (vgl. Fig. 1a) um 180° gedreht. Damit ist die Sputterrichtung S2 während der Einsputterphase der Sputterrichtung S1 während des regulären Betriebs entgegengesetzt. Ein Auffangblech 5' ist dementsprechend an der Rückseite des Kompartments 1' angeordnet.

Selbstverständlich kann die Kathode 2, 2' für das Einsputtern in jede beliebige, von der Transportebene 4 abgewandte Richtung, beispielsweise schräg nach hinten, gedreht werden. Dementsprechend werden auch die Abfangbleche 5, 5' in dieser Richtung angeordnet sein.

Im Beispiel gemäß der Fig. 1b entspricht die Drehachse der jeweiligen Kathode 2, 2' einer zentralen Längsachse der Kathode 2, 2'. Die Drehachse kann jedoch auch versetzt sein, beispielsweise seitlich versetzt. Die Kathode 2, 2' kann durch einen beliebigen Mechanismus gedreht, verkippt oder geschwenkt werden. Der Drehmechanismus weist im vorliegenden Fall beispielsweise einen motorischen Antrieb auf. Dieser kann im Kathodenaufbau oder im Beschichtungskompartment 1, 1' integriert sein.

In der Fig. 1b sind zwei unterschiedliche Kathodenstellungen speziell für das Einsputtern der Targets 3, 3' dargestellt. Die während des Einsputterns vom Target 3, 3' abgelösten Teilchen werden von den Blechen 5 bzw. 5' aufgefangen. Die Bleche 5 und 5' können zusammen mit dem Target 3, 3' beim Targetwechsel ausgetauscht werden.

Sobald ein Target 3, 3' betriebsbereit ist, werden die Kathoden 2, 2' in die in der Fig. 1a dargestellte Betriebsposition mit der Sputterrichtung S in Richtung der Substratebene 4 parallel zur Targetoberfläche 3, 3' gedreht. In dieser Position der Targets 3, 3' können die Substrate 4a, 4b, 4c

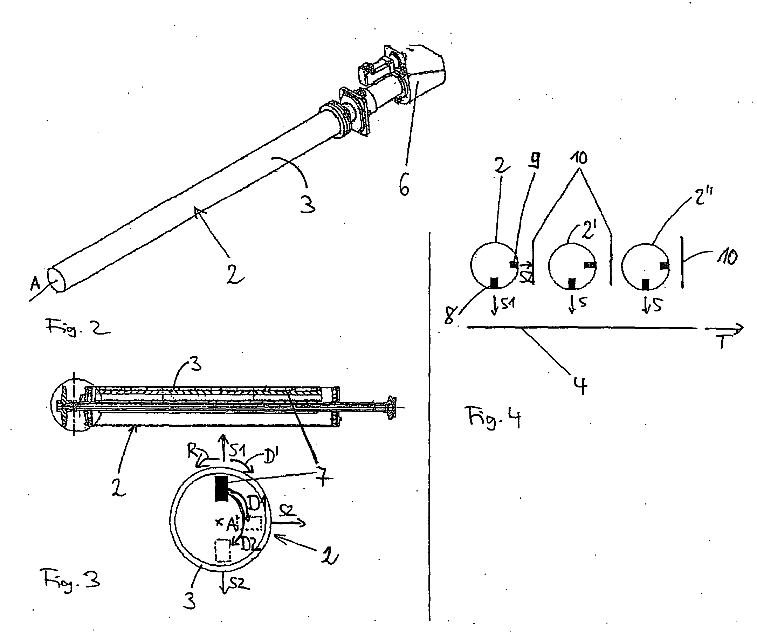

Die Fig. 2 zeigt einen Kathodenaufbau mit einer im Wesentlichen zylindrisch ausgebildeten Drehkathode 2, die beispielsweise im Bereich der Glasbeschichtung, der Bildschirmherstellung und dergleichen eingesetzt werden kann. Das Targetmaterial 3 ist, wie aus der Schnittansicht gemäß Fig. 3 ersichtlich, bei dem dargestellten Kathodenaufbau auf einer im Wesentlichen zylindrischen Trägerstruktur angeordnet. Die rotierbare Kathode 2 wird im Betrieb zur gleichmäßigen Ausnutzung und Abtragung des Materials vom Target mittels eines Antriebs 6 um seine zentrale Achse A gedreht.
Wie in der Fig. 3 in einer Schnittansicht entlang einer Längsachse bzw. senkrecht zu einer Längsachse der Kathode 2 dargestellt, weist die Kathode 2 ein Magnetsystem 7 zur Erhöhung der Sputterrate auf. Die Anordnung des Magnetsystems 7 bestimmt bei Drehkathoden wesentlich die Sputterrichtung S1, S2. Das Magnetsystem 7 ist bei der vorliegenden Ausführungsform, wie insbesondere aus dem radialen Schnittbild hervorgeht, radial in einer bestimmten Richtung S1, die im Wesentlichen der Sputterrichtung entspricht, angeordnet. Damit ist auch das Magnetfeld in dieser Richtung orientiert. Für den bestimmungsgemäßen Beschichtungsbetrieb ist das Magnetsystem 7 stationär in der Beschichtungskammer angeordnet, während das Target 3 in der durch den Pfeil R angedeuteten Richtung um die Kathodenlängsachse rotiert. Das Magnetsystem 7 ist in diesem Betriebsmodus so ausgerichtet, dass die Sputterrichtung S1 im Wesentlichen senkrecht zur Oberfläche der Substrate (nicht gezeigt), die beschichtet werden sollen, orientiert ist.

Während bei herkömmlichen Beschichtungsanlagen mit Drehkathoden während der Einsputterphase Substrate, die später entsorgt werden müssen, oder Dummies besputtert werden, kann bei der erfindungsgemäßen Anordnung das Magnetsystem 7 der Drehkathode 2 um eine axiale Achse A gedreht werden, um die Sputterrichtung S zu verändern. Ähnlich wie in Zusammenhang mit der Flachkathode 2 in Fig. 1 gezeigt, kann das Magnetfeld beispielsweise um 90° zur Seite (Pfeil D1), um 180° nach hinten (Pfeil D2), oder in jede beliebige Richtung, z.B. schräg nach hinten von der Substratoberfläche bzw. Transportebene weg gedreht werden. Bei der Wahl des Drehwinkels kann die Anlagenbeschaffenheit berücksichtigt werden Sobald das Target betriebsbereit ist, wird das Magnetsystem 7 (und damit die Sputterrichtung) zu den Substraten bzw. zur Substrattransportebene hin gerichtet.

In der Fig. 3 ist die Drehung der Magnetanordnung 7 in eine Position, die das Magsystem 7 zum Einsputtern einnehmen soll, durch die Pfeile D1 und D2 und die in Strichlinien angedeuteten Positionen des Magnetsystems 7 nach der Drehung verdeutlicht. Mit der Magnetanordnung 7 wird demnach die Sputterrichtung von einer Richtung S1 für den Beschichtungsbetrieb in jeweils eine ausgewählte Richtung S2 für das Einsputtern gedreht.

Es kann jedoch auch vorgesehen sein, dass für das Einsputtern die gesamte Kathode 2 zusammen mit dem Magnetsystem 7, wie in der Fig. 3 durch den Pfeil D' angedeutet, gedreht wird. Der Drehwinkel kann dabei entsprechend der Anlagenkonfiguration gewählt werden.

Der Drehmechanismus für das Magnetsystem 7 kann beliebig ausgebildet sein. Beispielsweise kann ein motorischer Antrieb vorgesehen sein, mit dessen Hilfe das Magnetsystem 7 zwischen der Einsputterphase und dem Beginn des regulären Beschichtungsbetriebs um die Kathodenlängsachse A gedreht werden kann.

In Abhängigkeit von den Platzverhältnissen kann eine Drehung des Magnetsystems 7 zwischen der Einsputterposition und der Betriebsposition durch den Einsatz einer weiteren Drehdurchführung realisiert werden. Dabei könnte die gesamte Kathode 1 um einen entsprechenden Winkel oder lediglich der Magnetträger, mit dem das Magnetsystem 7 verbunden ist, drehbar sein. Es könnte auch ein separater Träger für das Magnetsystem 7 vorgesehen sein, der zusammen mit dem Magnetsystem 7 gegenüber der Kathode 1 gedreht werden kann.

Auch beim Einsatz von Drehkathoden 2 sind in der Beschichtungskammer Bleche bzw. Auffangoberflächen in der für das Einsputtern vorgesehenen Sputterrichtung S2 angeordnet. Die Bleche sind so ausgebildet und angeordnet, dass während des Einsputterns kein abgesputtertes Material auf die Substrate bzw. auf die Transportebene trifft. Die Bleche können zusammen mit dem Target 3 beim Targetwechsel ausgetauscht werden.

Eine weitere alternative Ausführungsform ist in der Fig. 4 dargestellt. Die Figur zeigt einen Ausschnitt aus einer Beschichtungsanlage mit drei hintereinander angeordneten Drehkathoden 2, 2', 2". Jede dieser Kathoden 2, 2', 2" weist eine erste Magnetanordnung 8 auf, die ein Magnetfeld in Richtung der Substratebene 4 erzeugt, so dass eine erste Sputterrichtung S1 im regulären, bestimmungsgemäßen Beschichtungsbetrieb im Wesentlichen senkrecht zur Substratoberfläche 4 ausgerichtet ist. Darüber hinaus weist jedoch jede der Kathoden 2, 2', 2" noch eine weitere Magnetanordnung 9 auf, die ein Magnetfeld derart erzeugt, dass die Sputterrichtung in eine von der Transportebene 4 abgewandte Richtung S2 gedreht wird. Dieses zweite, abgewandte Magnetfeld sorgt dafür, dass während der Einsputterphase das gesputterte Material von den seitlich neben der Kathode 2 angeordneten Blechen 10 aufgegangen wird. Insbesondere bei einer Beschichtungsanlage mit vertikal angeordneten Kathoden 2, 2', 2" ist die zweite Sputterrichtung S2 um 180° gegenüber der ersten gedreht. Auf diese Weise wird die geringst mögliche Beeinträchtigung der Produktionsbeschichtung während des bestimmungsgemäßen Beschichtungsbetriebs durch evtl. vom Auffangblech 10 abplatzende Partikel erreicht. Gleiches gilt jedoch auch für Anlagen mit horizontaler Ausrichtung der Kathoden, beispielsweise bei Glasbeschichtungsanlagen, die im "Sputter-up"-Verfahren (Sputterrichtung S1 nach oben) betrieben werden. Bei Anlagen mit horizontaler Aussichtung der Kathoden im "Sputter-down"-Verfahren (Sputterrichtung S1 nach unten), ist dagegen eine zweite Sputterrichtung S2 günstiger, die gegenüber der für den Beschichtungsbetrieb gewählten Sputterrichtung S1 um ca. 90° verdreht ist, wie dies auch in der Fig. 4 dargestellt ist. Bei dieser Anordnung kann das Auffangblech 10 so geformt sein, dass die herab fallenden Partikel aufgefangen werden. Beispielsweise kann ein Blech mit einem L-förmigen Querschnitt verwendet werden, in dessen im wesentlichen horizontalen Abschnitt sich die herab fallenden Partikel sammeln. Es ist klar, dass eine 180°-Drehung der beiden Sputterrichtungen S1 und S2 zueinander im "Sputter-down"-Verfahren weniger günstig wäre, da das Auffangblech in diesem Fall oberhalb der Kathode bzw. der Substrattransportebene 4 angeordnet wäre und so die abplatzenden Partikel auf die vorbeifahrenden Substrate fallen müssten.

Wie bereits vorher beschrieben, könnte die Sputterrichtung S2 für den Einsputterbetrieb jedoch auch schräg oder um 180° nach hinten ausgerichtet sein. Die Auffangbleche 10 würden dementsprechend angeordnet werden, so dass der Innenraum der Beschichtungskammer möglichst wenig verschmutzt wird.
Beim Betrieb der Anlage wird während der Einsputterphase lediglich das zweite Magnetsystem 9 in die Kathode aktiviert, während im regulären Beschichtungsbetrieb das erste Magnetsystem 8 eingesetzt bzw. aktiviert ist. Es versteht sich von selbst, dass die Aktivierung des ersten bzw. des zweiten Magnetsystems 8, 9 ohne vorheriges Fluten der Anlage durchgeführt werden kann, so dass ein direkter Betriebsübergang zwischen den beiden Betriebsphasen stattfinden kann.

Für alle beschriebenen Ausführungsformen ist die Erfindung sowohl bei senkrechtem, horizontalem oder schrägem Einbau der Einbaukathoden bzw. der Drehkathoden, je nach Art der Beschichtungsanlage, durchführbar. Entsprechend können auch die Auffangeinrichtungen horizontal, schräg bzw. vertikal angeordnet sein.

Zum Auffangen von Material, das sich unbeabsichtigt von den Auffangblechen löst, können unterhalb der Bleche Behälter zum Auffangen dieses Materials angeordnet sein.

Mit Hilfe der vorgeschlagenen Lösungen kann auf den Einsatz von Substraten, die während der Einsputterphase beschichtet werden, oder auf den Einsatz von Dummy-Trägem verzichtet werden. Damit können die Betriebskosten insgesamt gesenkt werden. Außerdem entfällt die Notwendigkeit einer Entsorgung der Substrate bzw. der Dummies, die während der Einsputterphase beschichtet worden sind.

## Patentansprüche

1. Beschichtungsanlage zur Beschichtung eines Substrats (4a, 4b, 4c) mittels Sputtern, umfassend eine Prozesskammer und ein in der Prozesskammer angeordnetes Target (3, 3'), von dem aus Targetmaterial in Richtung des Substrats (4a, 4b, 4c) zum Beschichten des Substrats (4a, 4b, 4c) absputterbar ist, **dadurch gekennzeichnet, dass**
die Beschichtungsanlage Mittel zur Ausrichtung der Sputterrichtung (S) in der Prozesskammer in eine erste Richtung (S1) zum Betreiben der Beschichtungsanlage in einem ersten Betriebsmodus, und zur Ausrichtung der Sputterrichtung (S) in der Prozesskammer in eine zweite Richtung (S2) zum Betreiben der Beschichtungsanlage in einem zweiten Betriebsmodus aufweist, wobei
die erste Richtung (S1) eine zum Substrat (4a, 4b, 4c) hin gerichtete Richtung, und die zweite Richtung (S2) eine vom Substrat (4a, 4b, 4c) abgewandte Richtung ist.

2. Beschichtungsanlage nach Anspruch 1, **dadurch gekennzeichnet, dass**
die Beschichtungsanlage zum Beschichten des Substrats (4a, 4b, 4c) durch Absputtern von Material vom Target (3, 3') in den ersten Betriebsmodus, und zum Einsputtern des Targets (3, 3') in den zweiten Betriebsmodus einstellbar ist.

3. Beschichtungsanlage nach Anspruch 1 oder 2, **dadurch gekennzeichnet, dass** die Mittel zur Ausrichtung der Sputterrichtung (S) derart ausgebildet sind, dass die Sputterrichtung (S) durch eine Drehung der Sputterrichtung (S) um einen Winkel, insbesondere einem Winkel zwischen 90° und 180°, veränderbar ist.

4. Beschichtungsanlage nach einem der vorhergehenden Ansprüche, **dadurch gekennzeichnet, dass**
die Beschichtungsanlage eine Auffangeinrichtung (5, 5', 10) zum Auffangen von in die erste Richtung vom Target abgesputtertem Material aufweist.

5. Beschichtungsanlage nach Anspruch 4, **dadurch gekennzeichnet, dass**
die Auffangeinrichtung (5, 5', 10) so angeordnet und ausgebildet ist, dass die durch ihren Rand beschriebene Öffnungs- bzw. Auftrefffläche im wesentlichen senkrecht zur zweiten Richtung angeordnet ist.

6. Beschichtungsanlage nach einem der vorhergehenden Ansprüche, **dadurch gekennzeichnet, dass**
die Beschichtungsanlage eine Flachkathode (2, 2') aufweist, die das Target (3, 3') trägt.

7. Beschichtungsanlage nach Anspruch 6, **dadurch gekennzeichnet, dass**
die Mittel zur Ausrichtung der Sputterrichtung (S) einen Drehmechanismus zur Drehung der Flachkathode (2, 2') aufweisen.

8. Beschichtungsanlage nach Anspruch 7, **dadurch gekennzeichnet, dass**
der Drehmechanismus ausgebildet ist, so dass die Flachkathode (2, 2') um eine Längsachse der Kathode (2, 2') drehbar ist.

9. Beschichtungsanlage nach einem der Ansprüche 6 bis 8, **dadurch gekennzeichnet, dass**
Die Kathode (2, 2') zum Einsputtern des Targets gegenüber der Substratoberfläche um einen Winkel, insbesondere einem Winkel zwischen 90° und 180°, verkippt oder geschwenkt werden kann.

10. Beschichtungsanlage nach einem der Ansprüche 8 oder 9, **dadurch gekennzeichnet, dass**
der Drehmechanismus einen motorischen Antrieb aufweist.

11. Beschichtungsanlage nach einem der Ansprüche 1 bis 5, **dadurch gekennzeichnet, dass**
die Beschichtungsanlage eine Drehkathode (2, 2', 2") aufweist, die das Target (3) trägt, wobei das Target (3) gegenüber einer Trägerstruktur der Kathode (2, 2', 2") drehbar angeordnet ist.

12. Beschichtungsanlage nach Anspruch 11, **dadurch gekennzeichnet, dass**
die Beschichtungsanlage ein Magnetsystem (7) aufweist, das mittels eines Drehmechanismus gegenüber der Trägerstruktur der Kathode (2) drehbar angeordnet ist.

13. Beschichtungsanlage nach Anspruch 12, **dadurch gekennzeichnet, dass** das Magnetsystem (7) an einem Magnetträger angeordnet ist.

14. Beschichtungsanlage nach Anspruch 11, **dadurch gekennzeichnet, dass** die Kathode (2) mit ihrer Trägerstruktur und dem Magnetsystem (7) mittels eines Drehmechanismus drehbar in der Beschichtungskammer angeordnet ist.

15. Beschichtungsanlage nach einem der Ansprüche 12 bis 14, **dadurch gekennzeichnet, dass**
der Drehmechanismus einen motorischen Antrieb aufweist.

16. Beschichtungsanlage nach Anspruch 11, **dadurch gekennzeichnet, dass**
die Kathode (2, 2', 2") Mittel zur Anordnung eines ersten Magnetsystems (9) zur Ausrichtung der Sputterrichtung in die erste Richtung (S1), und Mittel zur Anordnung eines zweiten Magnetsystems (8) zur Ausrichtung der Sputterrichtung in die zweite Richtung (S2) aufweist.

17. Beschichtungsanlage nach Anspruch 16, **dadurch gekennzeichnet, dass**
das erste Magnetsystem (8) während des ersten Betriebsmodus aktiviert ist, und das zweite Magnetsystem (9) während des zweiten Betriebsmodus aktiviert ist.

18. Beschichtungsanlage nach Anspruch 17, **dadurch gekennzeichnet, dass**
das erste Magnetsystem (8) und/oder das zweite Magnetsystem (9) Elektromagnete umfassen, die durch An- bzw. Abschalten aktivierbar bzw. deaktivierbar sind.

19. Beschichtungsanlage nach Anspruch 17, **dadurch gekennzeichnet, dass**
das erste Magnetsystem (8) und/oder das zweite Magnetsystem (9) Permanentmagnete umfassen, wobei die Magnetsysteme (8, 9) jeweils durch Anordnung eines Abschirmelements, insbesondere eines weichmagnetischen Abschirmblechs, zwischen das jeweilige Magnetsystem (8, 9) und die Targetoberfläche (3, 3') aktivierbar bzw. deaktivierbar sind.

20. Beschichtungsanlage nach Anspruch 17, **dadurch gekennzeichnet, dass**
das erste Magnetsystem (8) und/oder das zweite Magnetsystem (9) Permanentmagnete umfassen, und die Magnetsysteme (8, 9) innerhalb des Targets (3, 3') schwenkbar angeordnet sind derart, dass die Magnetsysteme (8, 9) durch Verschwenken der Magnetpole des jeweiligen Magnetsystems (8, 9) bezüglich der Targetoberfläche (3, 3') jeweils aktivierbar bzw. deaktivierbar sind.

21. Verfahren zum Betrieb einer Beschichtungsanlage, insbesondere einer Beschichtungsanlage nach einem der vorhergehenden Ansprüche, **gekennzeichnet durch** folgende Schritte:
a) Einsetzen eines Targets (3, 3') in eine Beschichtungskammer;
b) Evakuieren der Beschichtungskammer;
c) Ausrichten der Sputterrichtung (S) in der Beschichtungskammer in eine erste, von einer Substratebene (4) abgewandte Richtung (S2);
d) Einsputtern des Targets (3, 3');
e) Ausrichten der Sputterrichtung (S) in der Beschichtungskammer in eine zweite, zur Substratebene (4) hin gerichtete Richtung (S1); und
f) Beschichten von Substraten (4a, 4b, 4c) **durch** Absputtern von Material vom Target (3, 3'),
wobei der Schritt c) vor oder nach dem Schritt b) durchgeführt werden kann.

22. Verfahren nach Anspruch 21, **dadurch gekennzeichnet, dass** zwischen der ersten Richtung und der zweiten Richtung ein Winkel, insbesondere ein Winkel zwischen 90° und 180°, liegt.

23. Verfahren nach Anspruch 21 oder 22, **dadurch gekennzeichnet, dass**
im Schritt a) neben dem Target (3, 3') in die Beschichtungskammer eine Auffangeinrichtung (5, 5', 10) zum Auffangen von in die erste Richtung abgesputtertem Material eingesetzt wird.

24. Verfahren nach Anspruch 23, **dadurch gekennzeichnet, dass**
die Auffangeinrichtung (5, 5', 10) so angeordnet wird, dass die durch ihren Rand beschriebene Öffnungs- bzw. Auftrefffläche im wesentlichen senkrecht zur zweiten Richtung ausgerichtet ist.

25. Verfahren nach einem der vorhergehenden Ansprüche 21 bis 24, **dadurch gekennzeichnet, dass**
die Sputterrichtung (S) im Schritt e) durch Drehen einer Flachkathode (2, 2') ausgerichtet wird.

26. Verfahren nach Anspruch 25, **dadurch gekennzeichnet, dass**
die Sputterrichtung (S) um einen Winkel, insbesondere einem Winkel zwischen 90° und 180°, verkippt wird.

27. Verfahren nach einem der vorhergehenden Ansprüche 21 bis 24, **dadurch gekennzeichnet, dass**
die Sputterrichtung (S) im Schritt e) durch Drehen eines Magnetsystems (7) einer Drehkathode oder durch Drehen der das Magnetsystem tragenden Rohrkathode (2) ausgerichtet wird.

28. Verfahren nach einem der vorhergehenden Ansprüche 21 bis 24, **dadurch gekennzeichnet, dass**
die Ausrichtung der Sputterrichtungen (S) in den Schritten c) und e) durch Aktivieren bzw. Deaktivieren wenigstens zweier Magnetanordnungen, die in einer Drehkathode radial versetzt angeordnet werden können, erfolgt.

## Claims

1. Coating installation for coating of a substrate (4a, 4b, 4c) by means of sputtering, comprising a process chamber and a target (3, 3') disposed in the process chamber, from which target material can be sputtered in the direction of the substrate (4a, 4b, 4c) for coating of the substrate (4a, 4b, 4c), **characterised in that** the coating installation has means for orienting the sputter direction (S) in the process chamber in a first direction (S1) for operation of the coating installation in a first operating mode and for orienting the sputter direction (S) in the process chamber in a second direction (S2) for operation of the coating installation in a second operating mode, wherein the first direction (S1) is a direction towards the substrate (4a, 4b, 4c) and the second direction (S2) is a direction away from the substrate (4a, 4b, 4c).

2. Coating installation as claimed in Claim 1, **characterised in that** the coating installation can be set in the first operating mode for coating of the substrate (4a, 4b, 4c) by sputtering material from the target (3, 3') and in a second operating mode for sputtering the target (3, 3').

3. Coating installation as claimed in Claim 1 or Claim 2, **characterised in that** the means for orienting the sputter direction (S) are constructed in such a way that the sputter direction (S) can be varied by rotation of the sputter direction (S) by an angle, in particular an angle between 90° and 180°.

4. Coating installation as claimed in any one of the preceding claims, **characterised in that** the coating installation has a collecting device (5, 5', 10) for collection of material sputtered from the target in the first direction.

5. Coating installation as claimed in Claim 4, **characterised in that** the collecting device (5, 5', 10) is disposed and constructed in such a way that the opening or impact surface described by its edge is disposed substantially perpendicular to the second direction.

6. Coating installation as claimed in any one of the preceding claims, **characterised in that** the coating installation has a flat cathode (2, 2') which carries the target (3, 3').

7. Coating installation as claimed in Claim 6, **characterised in that** the means for orienting the sputter direction (S) comprises a rotary mechanism for rotating the flat cathode (2, 2').

8. Coating installation as claimed in Claim 7, **characterised in that** the rotary mechanism is constructed in such a way that the flat cathode (2, 2') is rotatable about a longitudinal axis of the cathode (2, 2').

9. Coating installation as claimed in any one of Claims 6 to 8, **characterised in that** the cathode (2, 2') can be tilted or pivoted by an angle, in particular an angle between 90° and 180°, relative to the substrate surface for sputtering of the target.

10. Coating installation as claimed in any one of Claims 8 or 9, **characterised in that** the rotary mechanism has a motor drive.

11. Coating installation as claimed in any one of Claims 1 to 5, **characterised in that** the coating installation has a rotary cathode (2, 2', 2") which carries the target (3), wherein the target (3) is disposed so as to be rotatable relative to a carrier structure of the cathode (2, 2', 2").

12. Coating installation as claimed in Claim 11, **characterised in that** the coating installation has a magnet system (7) which is disposed so as to be rotatable relative to the carrier structure of the cathode (2) by means of a rotary mechanism.

13. Coating installation as claimed in Claim 12, **characterised in that** the magnet system (7) is disposed on a magnet carrier.

14. Coating installation as claimed in Claim 11, **characterised in that** the cathode (2) with its carrier structure and the magnet system (7) is disposed in the coating chamber so as to be rotatable by means of a rotary mechanism.

15. Coating installation as claimed in any one of Claims 12 to 14, **characterised in that** the rotary mechanism has a motor drive.

16. Coating installation as claimed in Claim 11, **characterised in that** the cathode (2, 2', 2") has means for disposing a first magnet system (9) for orienting the sputter direction in the first direction (S1) and means for disposing a second magnet system (8) for orienting the sputter direction in the second direction (S2).

17. Coating installation as claimed in Claim 16, **characterised in that** the first magnet system (8) is activated during the first operating mode and the second magnet system (9) is activated during the second operating mode.

18. Coating installation as claimed in Claim 17, **characterised in that** the first magnet system (8) and/or the second magnet system (9) comprise electromagnets which can be activated or deactivated by being switched on or off respectively.

19. Coating installation as claimed in Claim 17, **characterised in that** the first magnet system (8) and/or the second magnet system (9) comprises permanent magnets, wherein the magnet systems (8, 9) can each be activated and deactivated by the arrangement of a shielding element, in particular a soft magnetic shielding plate, between the respective magnet system (8, 9) and the target surface (3, 3').

20. Coating installation as claimed in Claim 17, **characterised in that** the first magnet system (8) and/or the second magnet system (9) comprises permanent magnets, and the magnet systems (8, 9) inside the target (3, 3') are disposed so as to be pivotable in such a way that the magnet systems (8, 9) can each be activated and deactivated by pivoting of the magnet poles of the respective magnet system (8, 9) relative to the target surface (3, 3').

21. Method of operating a coating installation, in particular a coating installation as claimed in any one of the preceding claims, **characterised by** the following steps:
(a) insertion of a target (3, 3') into a coating chamber;
(b) evacuation of the coating chamber;
(c) orientation of the sputter direction (S) in the coating chamber in a first direction (S2) away from a substrate plane (4);
(d) sputtering of the target (3, 3'),
(e) orientation of the sputter direction (S) in a second direction (S1) towards the substrate plane (4); and
(f) coating of substrates (4a, 4b, 4c) by sputtering of material from the target (3, 3'),
wherein the step (c) can be carried out before or after the step (b).

22. Method as claimed in Claim 21, **characterised in that** an angle, in particular an angle between 90° and 180°, lies between the first direction and the second direction.

23. Method as claimed in Claim 21 or Claim 22, **characterised in that** in step (a) in addition to the target (3, 3') a collecting device (5, 5', 10) for collecting material sputtered in the first direction is inserted into the coating chamber.

24. Method as claimed in Claim 23, **characterised in that** the collecting device (5, 5', 10) is disposed so that the opening or impact surface described by its edge is oriented substantially perpendicular to the second direction.

25. Method as claimed in any one of the preceding Claims 21 to 24, **characterised in that** in step (e) the sputter direction (S) is oriented by rotation of a flat cathode (2, 2').

26. Method as claimed in Claim 25, **characterised in that** the sputter direction (S) is tilted by an angle, in particular an angle between 90° and 180°.

27. Method as claimed in any one of the preceding Claims 21 to 24, **characterised in that** in step (e) the sputter direction (S) is oriented by rotation of a magnet system (7) of a rotary cathode or by rotation of the tubular cathode (2) carrying the magnet system.

28. Method as claimed in any one of the preceding Claims 21 to 24, **characterised in that** the orientation of the sputter directions (S) in steps (c) and (e) takes place by activation or deactivation of at least two magnet arrangements which can be disposed so that they are radially offset in a rotary cathode.

## Revendications

1. Installation de revêtement pour le revêtement d'un substrat (4a, 4b, 4c) par pulvérisation cathodique, comprenant une chambre de traitement et une cible (3, 3') placée dans la chambre de traitement, cible à partir de laquelle la matière de la cible peut être pulvérisée en direction du substrat (4a, 4b, 4c) en vue de revêtir le substrat (4a, 4b, 4e), **caractérisée en ce que**
l'installation de revêtement comporte des moyens permettant d'orienter la direction (S) de pulvérisation dans la chambre de traitement selon une première direction (S1) en vue de faire fonctionner l'installation de revêtement dans un premier mode de fonctionnement, et pour orienter la direction (S) de pulvérisation dans la chambre de traitement selon une deuxième direction (S2) en vue de faire fonctionner l'installation de revêtement dans un deuxième mode de fonctionnement, dans laquelle la première direction (S1) est une direction orientée vers le substrat (4a, 4b, 4e) et la deuxième direction (S2) est une direction opposée au substrat (4a, 4b, 4c).

2. Installation de revêtement selon la revendication 1, **caractérisée en ce que**
l'installation de revêtement peut être commutée dans le premier mode de fonctionnement pour revêtir le substrat (4a, 4b, 4e) par pulvérisation cathodique effective de matière de la cible (3, 3') et dans le deuxième mode de fonctionnement pour prépulvériser la cible (3, 3').

3. Installation de revêtement selon la revendication 1 ou 2,
**caractérisée en ce que**
les moyens d'orientation de la direction (S) de pulvérisation sont configurés de telle sorte que la direction (S) de pulvérisation est modifiable par rotation de la direction (S) de pulvérisation selon un certain angle, en particulier un angle compris entre 90° et 180°.

4. Installation de revêtement selon l'une quelconque des revendications précédentes, **caractérisée en ce que**
l'installation de revêtement présente un dispositif collecteur (5, 5', 10) en vue de collecter la matière de la cible pulvérisée dans la première direction.

5. Installation de revêtement selon la revendication 4, **caractérisée en ce que**
le dispositif collecteur (5, 5', 10) est placé et réalisé de telle sorte que la surface d'ouverture ou d'impact délimitée par le bord de celui-ci est essentiellement disposée perpendiculairement à la deuxième direction.

6. Installation de revêtement selon l'une quelconque des revendications précédentes, **caractérisée en ce que**
l'installation de revêtement présente une cathode plane (2, 2') qui supporte la cible (3, 3').

7. Installation de revêtement selon la revendication 6, **caractérisée en ce que**
les moyens d'orientation de la direction (S) de pulvérisation présentent un mécanisme de rotation destiné à faire tourner la cathode plane (2, 2').

8. Installation de revêtement selon la revendication 7, **caractérisée en ce que**
le mécanisme de rotation est configuré de telle sorte que la cathode plane (2, 2') peut tourner autour d'un axe longitudinal de la cathode (2, 2').

9. Installation de revêtement selon l'une quelconque des revendications 6 à 8, **caractérisée en ce que**
en vue de la prépulvérisation de la cible, la cathode (2, 2') peut être pivotée ou tournée selon un certain angle par rapport à la surface du substrat, en particulier selon un angle compris entre 90° et 180°.

10. Installation de revêtement selon l'une quelconque des revendications 8 ou 9, **caractérisée en ce que** le mécanisme de rotation présente un entraînement motorisé.

11. Installation de revêtement selon l'une quelconque des revendications 1 à 5, **caractérisée en ce que**
l'installation de revêtement présente une cathode rotative (2, 2', 2") portant la cible (3), dans laquelle la cible (3) est disposée de façon à pouvoir tourner par rapport à une structure de support de la cathode (2, 2', 2").

12. Installation de revêtement selon la revendication 11, **caractérisée en ce que**
l'installation de revêtement présente un système magnétique (7) disposé de façon à pouvoir tourner grâce à un mécanisme de rotation par rapport à la structure de support de la cathode (2).

13. Installation de revêtement selon la revendication 12, **caractérisée en ce que**
le système magnétique (7) est placé sur un support magnétique.

14. Installation de revêtement selon la revendication 11, **caractérisée en ce que**
la cathode (2) est disposée dans la chambre de revêtement de façon à pouvoir tourner conjointement avec sa structure de support et le système magnétique (7) grâce à un mécanisme de rotation.

15. Installation de revêtement selon l'une quelconque des revendications 12 à 14, **caractérisée en ce que** le mécanisme de rotation présente un entraînement motorisé.

16. Installation de revêtement selon la revendication 11, **caractérisée en ce que**
la cathode (2, 2', 2") comporte des moyens d'orientation d'un premier système magnétique (9) pour l'orientation de la direction de pulvérisation dans la première direction (S1), et des moyens d'orientation d'un deuxième système magnétique (8) pour l'orientation de la direction de pulvérisation dans la deuxième direction (S2).

17. Installation de revêtement selon la revendication 16, **caractérisée en ce que**
le premier système magnétique (8) est activé dans le premier mode de fonctionnement et le deuxième système magnétique (9) est activé dans le deuxième mode de fonctionnement.

18. Installation de revêtement selon la revendication 17, **caractérisée en ce que**
le premier système magnétique (8) et/ou le deuxième système magnétique (9) comprennent des électroaimants pouvant être activés ou désactivés à l'aide d'une mise en circuit/hors circuit.

19. Installation de revêtement selon la revendication 17, **caractérisée en ce que**
le premier système magnétique (8) et/ou le deuxième système magnétique (9) comprennent des aimants permanents, dans laquelle chaque système magnétique (8, 9) peut être activé ou désactivé en plaçant un élément de blindage, en particulier une tôle de blindage magnétique douce, entre le système magnétique (8, 9) concerné et la surface de la cible (3, 3').

20. Installation de revêtement selon la revendication 17, **caractérisée en ce que**
le premier système magnétique (8) et/ou le deuxième système magnétique (9) comprennent des aimants permanents et les systèmes magnétiques (8, 9) sont disposés à l'intérieur de la cible (3, 3') de façon à pouvoir pivoter de telle sorte que les systèmes magnétiques (8, 9) peuvent être activés ou désactivés en faisant pivoter les pôles magnétiques du système magnétique (8, 9) concerné par rapport à la surface de la cible (3, 3').

21. Procédé de fonctionnement d'une installation de revêtement, en particulier d'une installation de revêtement selon l'une quelconque des revendications précédentes, **caractérisé par** les étapes suivantes :
a) mise en place d'une cible (3, 3') dans une chambre de revêtement ;
b) mise sous vide de la chambre de revêtement ;
c) orientation de la direction (S) de pulvérisation dans la chambre de revêtement dans une première direction (S2) opposée à un plan du substrat (4) ;
d) prépulvérisation de la cible (3, 3') ;
e) orientation de la direction (S) de pulvérisation dans la chambre de revêtement dans une deuxième direction (S1) dirigée vers le plan du substrat (4) ; et
f) revêtement des substrats (4a, 4b, 4c) par pulvérisation de matière de la cible (3, 3'),
dans lequel l'étape c) peut être réalisée avant ou après l'étape b).

22. Procédé selon la revendication 21, **caractérisé en ce que** un angle, en particulier un angle compris entre 90° et 180°, est formé entre la première direction et la deuxième direction.

23. Procédé selon la revendication 21 ou 22, **caractérisé en ce que**
dans l'étape a), un dispositif collecteur (5, 5', 10) est disposé dans la chambre de revêtement à proximité de la cible (3, 3') en vue de collecter la matière pulvérisée dans la première direction.

24. Procédé selon la revendication 23, **caractérisé en ce que** le dispositif collecteur (5, 5', 10) est disposé de telle sorte que la surface d'ouverture ou d'impact délimitée par le bord de celui-ci est essentiellement orientée perpendiculairement à la deuxième direction.

25. Procédé selon l'une quelconque des revendications précédentes 21 à 24, **caractérisé en ce que**
la direction (S) de pulvérisation est orientée à l'étape e) par rotation d'une cathode plane (2, 2').

26. Procédé selon la revendication 25, **caractérisé en ce que**
la direction (S) de pulvérisation est tournée selon un certain angle, en particulier selon un angle compris entre 90° et 180°.

27. Procédé selon l'une quelconque des revendications précédentes 21 à 24, **caractérisé en ce que**
la direction (S) de pulvérisation est orientée à l'étape e) par la rotation d'un système magnétique (7) d'une cathode rotative ou par la rotation de la cathode tubulaire (2) portant le système magnétique.

28. Procédé selon l'une quelconque des revendications précédentes 21 à 24, **caractérisé en ce que**
l'orientation des directions (S) de pulvérisation dans les étapes c) et e) est réalisée par l'activation ou la désactivation d'au moins deux ensembles magnétiques qui peuvent être installés de manière radialement décalée l'un par rapport à l'autre à l'intérieur d'une cathode rotative.
